# EUROPEAN PATENT APPLICATION

(11) **EP 4 697 558 A1**
(43) Date of publication of application: **18.02.2026**
(21) Application number: 25194417.9
(22) Date of filing: 06.08.2025
(51) Int. Cl.: H02J 7/60, H02J 7/80

(54) **BATTERY MANAGEMENT SYSTEM INCLUDING WAKE-UP FUNCTION AND BATTERY MANAGEMENT SYSTEM WAKE-UP METHOD**

(30) Priority: 13.08.2024 KR 20240108104
(71) Applicant: SAMSUNG SDI CO., LTD., Yongin-si, Gyeonggi-do 17084 (KR)
(72) Inventor: KAM, Jaewoo, 17084 Yongin-si (KR); SEO, Youngdong, 17084 Yongin-si (KR)
(74) Representative: Marks & Clerk LLP

(57) **Abstract**

The present disclosure relates to a wake-up function included in a battery management system (BMS) and a BMS wake-up method using the same. The BMS includes a micro-controller unit (MCU) configured to manage a battery, and a protection circuit configured to monitor the battery. When the protection circuit detects an abnormality in the battery while the BMS is in one of a shutdown mode and a sleep mode, the protection circuit is configured to output a wake-up signal to the BMS.

## Description

### BACKGROUND

### 1. Field of the Disclosure

The present disclosure relates to a battery management system (BMS) for managing a secondary battery, and more specifically, to a wake-up function included in a BMS and a BMS wake-up method using the wake-up function.

### 2. Discussion of Related Art

Unlike primary batteries that cannot be recharged, secondary batteries can be discharged and recharged. Low-capacity secondary batteries are used in portable small electronic devices such as smartphones, feature phones, laptop computers, digital cameras, and camcorders. Large-capacity secondary batteries are widely used as power sources for driving motors in hybrid vehicles, electric vehicles, and the like as well as for power storage batteries. A secondary battery includes an electrode assembly formed of a positive electrode and a negative electrode, a case for accommodating the electrode assembly, and electrode terminals connected to the electrode assembly.

A battery module or pack may include a battery management system (BMS). The BMS measures and predicts a voltage (V), a current (I), and a temperature (T) of a battery installed in an electric vehicle or energy storage system through sensors and controls the battery to exhibit optimal performance. The BMS usually operates by receiving power from the battery, which may cause a problem of consuming power of the battery pack. In addition, even when there is no charging or discharging of the battery pack, the BMS may continuously monitor whether a voltage of the battery cell is abnormal, and the BMS is thereby consuming power. To solve this problem, when there is no charging or discharging of the battery pack for a certain period of time, the BMS enters a low-power mode (sleep mode) or a power-off mode (shutdown mode). In the sleep mode or shutdown mode the BMS is periodically turned on and woken up to check for abnormal behavior of the battery. But even in the case of being woken up periodically, there is a problem in that a certain level of power, albeit small, is consumed. Further, a separate circuit is required to effect the periodic wake-up.

The information disclosed in this section is for enhancement of understanding of the background of the present disclosure and therefore may contain information that does not constitute a related or prior art.

### SUMMARY OF THE DISCLOSURE

The present disclosure is directed to a method of effectively reducing power consumption and identifying abnormal behavior of a battery by executing a wake-up function within a battery management system (BMS) without adding separate components or circuits.

According to an aspect of the present disclosure, there is provided a BMS including a micro-controller unit (MCU) configured to manage a battery, and a protection circuit configured to monitor the battery, wherein, when the protection circuit detects an abnormality in the battery while the BMS is in a shutdown mode or a sleep mode, the protection circuit is configured to output a wake-up signal to the BMS.

According to another aspect of the present disclosure, there is provided a wake-up method of a BMS comprising a MCU and a protection circuit configured to monitor a battery, which includes using the MCU to determine that charging/discharging of the battery is completed or paused and putting the BMS into a shutdown mode or a sleep mode, monitoring, by the protection circuit, the battery while the BMS is in the shutdown mode or the sleep mode, and waking up the BMS by the protection circuit outputting a wake-up signal when the protection circuit detects an abnormality of the battery.

Aspects and features of the present disclosure are not limited to those described above, and other aspects and features not specifically mentioned herein will be clearly understood by those skilled in the art from the description below.

At least some of the above and other features of the invention are set out in the claims.

### BRIEF DESCRIPTION OF THE DRAWINGS

The drawings attached to the present specification illustrate embodiments of the present disclosure and further describe aspects and features of the present disclosure together with the detailed description below. Thus, the present disclosure should not be construed as being limited to the drawings.
FIG. 1 is a schematic diagram of a pouch-type secondary battery;
FIG. 2 is a cross-sectional view of a cylindrical secondary battery;
FIG. 3A is a top perspective view of an exterior of a prismatic secondary battery;
FIG. 3B is a cross-sectional view along I-I' of FIG. 3A;
FIG. 4 is an example diagram of a secondary battery module in which secondary batteries are disposed;
FIG. 5 is an example diagram of a secondary battery pack that can include the secondary battery module in FIG. 4;
FIG. 6 shows a vehicle including the secondary battery pack shown in FIG. 5;
FIG. 7 is a schematic diagram of a wake-up related configuration of a battery management system (BMS);
FIG. 8 is a schematic flowchart of a BMS wake-up method according to some embodiments of the present disclosure;
FIG. 9 is a schematic flowchart of the BMS wake-up method in a shutdown mode;
FIG. 10 is a diagram of a circuit that implements the BMS wake-up method of FIG. 9;
FIG. 11 is a schematic flowchart of a BMS wake-up method in a sleep mode;
FIG. 12 is a diagram of circuit that implements the BMS wake-up method of FIG. 11; and
FIG. 13 is an internal circuit diagram of S-8264A IC, which is one example of 2^{nd} protection circuit components.

### DETAILED DESCRIPTION OF EXAMPLE EMBODIMENTS

Hereinafter, embodiments of the present disclosure will be described, in detail, with reference to the accompanying drawings. The terms or words used in the present specification and claims are not to be narrowly interpreted according to their general or dictionary meanings and should be interpreted as having meanings and concepts that are consistent with the technical idea of the present disclosure on the basis of the principle that an inventor can be his/her own lexicographer to appropriately define concepts of terms to describe his/her invention in the best way.

The embodiments described in this specification and the configurations shown in the drawings are only some embodiments of the present disclosure and do not represent all of the aspects, features, and embodiments of the present disclosure. Accordingly, it should be understood that there may be various equivalents and modifications that can replace or modify one or more embodiments or features therein described herein at the time of filing this application.

It will be understood that if an element or layer is referred to as being "on," "connected to," or "coupled to" another element or layer, it may be directly on, connected, or coupled to the other element or layer or one or more intervening elements or layers may also be present. When an element or layer is referred to as being "directly on," "directly connected to," or "directly coupled to" another element or layer, there are no intervening elements or layers present. For example, if a first element is described as being "coupled" or "connected" to a second element, the first element may be directly coupled or connected to the second element or the first element may be indirectly coupled or connected to the second element via one or more intervening elements.

In the figures, dimensions of the various elements, layers, etc. may be exaggerated for clarity of illustration. The same reference numerals designate the same elements. As used herein, the term "and/or" includes any and all combinations of one or more of the associated listed items. Further, the use of "may" if describing embodiments of the present disclosure relates to "one or more embodiments of the present disclosure." Expressions, such as "at least one of" and "any one of," if preceding a list of elements, modify the entire list of elements and do not modify the individual elements of the list. When phrases such as "at least one of A, B and C", "at least one of A, B or C," "at least one selected from a group of A, B and C," or "at least one selected from among A, B and C" are used to designate a list of elements A, B and C, the phrase may refer to any and all suitable combinations or a subset of A, B and C, such as A, B, C, A and B, A and C, B and C, or A and B and C. As used herein, the terms "use," "using," and "used" may be considered synonymous with the terms "utilize," "utilizing," and "utilized," respectively. As used herein, the terms "substantially," "about," and similar terms are used as terms of approximation and not as terms of degree, and are intended to account for the inherent variations in measured or calculated values that would be recognized by those of ordinary skill in the art.

It will be understood that, although the terms first, second, third, etc. may be used herein to describe various elements, components, regions, layers, and/or sections, these elements, components, regions, layers, and/or sections should not be limited by these terms. These terms are used to distinguish one element, component, region, layer, or section from another element, component, region, layer, or section. Thus, a first element, component, region, layer, or section discussed below could be termed a second element, component, region, layer, or section without departing from the teachings of example embodiments.

Spatially relative terms, such as "beneath," "below," "lower," "above," "upper," and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" or "over" the other elements or features. Thus, the term "below" may encompass both an orientation of above and below. The device may be otherwise oriented (rotated 90 degrees or at other orientations), and the spatially relative descriptors used herein should be interpreted accordingly.

The terminology used herein is for the purpose of describing embodiments of the present disclosure and is not intended to be limiting of the present disclosure. As used herein, the singular forms "a" and "an" are intended to include the plural forms as well, unless the context clearly indicates otherwise. It will be further understood that the terms "includes," "including," "comprises," and/or "comprising," if used in this specification, specify the presence of stated features, integers, steps, operations, elements, and/or components but do not preclude the presence or addition of one or more other features, integers, steps, operations, elements, components, and/or groups thereof.

Numerical ranges disclosed and/or recited include all sub-ranges of the same numerical precision subsumed within the recited range. For example, a range of "1.0 to 10.0" includes all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein includes all lower numerical limitations subsumed therein, and any minimum numerical limitation recited in this specification includes all higher numerical limitations subsumed therein. Accordingly, Applicant reserves the right to amend this specification, including the claims, to expressly recite any sub-range subsumed within the ranges expressly recited herein. All such ranges are intended to be inherently described in this specification such that amending to expressly recite any such subranges would comply with the requirements of the EPC.

References to two compared elements, features, etc. as being "the same" may mean that they are "substantially the same." Thus, the phrase "substantially the same" may include a case having a deviation that is considered low in the art, for example, a deviation of 5% or less. In addition, if a certain parameter is referred to as being uniform in a given region, it may mean that it is uniform in terms of an average.

Throughout the specification, unless otherwise stated, each element may be singular or plural.

Arranging an element "above (or below)" or "on (or under)" another element may mean that the element may contact the upper (or lower) surface of the element, and element may also be interposed between the element and the arbitrary element located on (or under) the element.

In addition, it will be understood that if a component is referred to as being "linked," "coupled," or "connected" to another component, the elements may be directly "coupled," "linked" or "connected" to each other, or another component may be "interposed" between the components.

Throughout the specification, if "A and/or B" is stated, it means A, B or A and B, unless otherwise stated. That is, "and/or" includes any or all combinations of a plurality of items enumerated. When "C to D" is stated, it means C or more and D or less, unless otherwise specified.

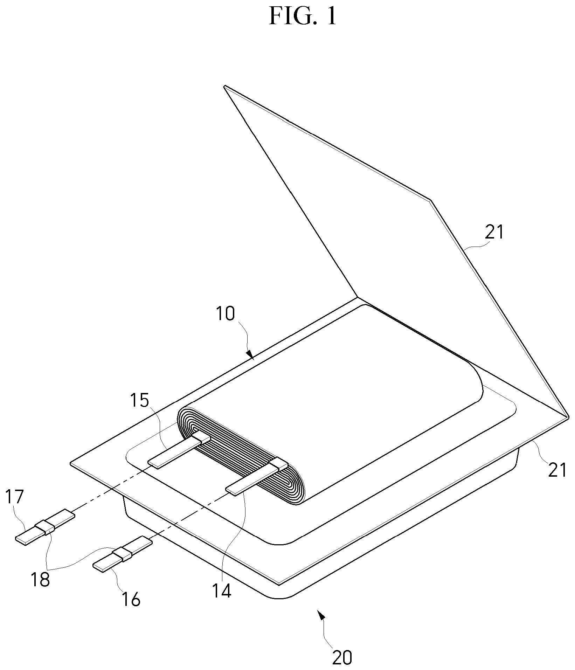

FIG. 1 schematically illustrates a pouch-type secondary battery. The pouch-type secondary battery includes an electrode assembly 10 and a pouch 20 that accommodates the electrode assembly 10. First and second electrode tabs 14 and 15 extend from the electrode assembly 10. The first electrode tab 14 and the second electrode tab 15 may be electrically connected to respective external first and second terminal leads 16 and 17 by welding. Each of the first terminal lead 16 and the second terminal lead 17 may be attached with a tab film 18 for insulation from the pouch 20.

The pouch 20 may be sealed by having sealing parts 21 at the edges of the pouch 20 contact each other with the electrode assembly 10 accommodated in the pouch 10. The sealing may be effected with a tab film 18 interposed between the sealing parts 21. The sealing parts 21 of the pouch 20 may each be made of a thermal fusion material that has weak adhesion to metal. Thus, the pouch 20 may be fused by interposing the thin tab film 18 between the sealing parts 21.

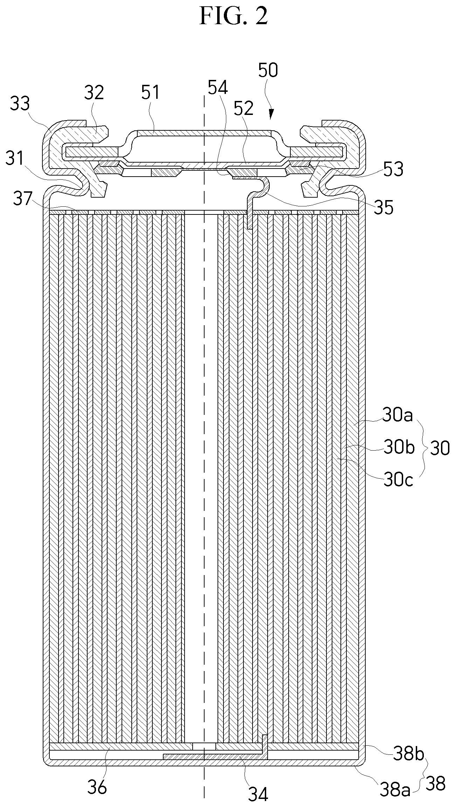

FIG. 2 illustrates a cylindrical secondary battery. The secondary battery includes an electrode assembly 30, a case 38 accommodating the electrode assembly 30 and an electrolyte therein. A cap assembly 50 is coupled to an opening of the case 38 to seal the case, and an insulating plate 37 is positioned between the electrode assembly 30 and the cap assembly 50 inside the case 38.

The electrode assembly 30 may include a first electrode 30c and a second electrode 30a positioned with a separator 30b interposed between the electrodes 30c and 30b. The electrode assembly 30 may be wound in a jelly-roll shape.

The first electrode 30c includes a first substrate and a first active material layer on the first substrate. A first lead tab 35 may extend outwardly from a first uncoated portion of the first substrate where the first active material layer is not provided. The first lead tab 35 may be electrically connected to the cap assembly 50.

The second electrode 30a includes a second substrate and a second active material layer on the second substrate. A second lead tab 34 may extend outwardly from a second uncoated portion of the second substrate where the second active material layer is not provided. The second lead tab 34 may be electrically connected to the case 38. The first lead tab 35 and the second lead tab 34 may extend in opposite directions from sides of the electrode assembly 30.

The first electrode 30c may act as a positive electrode. In such embodiments, the first substrate may be made of, for example, an aluminum foil, and the first active material layer may include, for example, a transition metal oxide. The second electrode 30a may act as a negative electrode. In such embodiments, the second substrate may be made of, for example, a copper foil or a nickel foil, and the second active material layer may include, for example, graphite.

The separator 30b prevents a short circuit between the first electrode 30c and the second electrode 30a while allowing movement of lithium ions between the electrodes 30a and 30b. The separator 32b may be made of, for example, a polyethylene film, a polypropylene film, a polyethylene-polypropylene film, or the like.

The case 38 accommodates the electrode assembly 30 and, together with the cap assembly 50, forms the external appearance of the secondary battery. The case 38 may have a substantially cylindrical body portion 38b and a bottom portion 38a at one side of the body portion 38b. A beading part 31 (e.g., a bead) deformed inwardly may be formed in the body portion 38b, and a crimping part 33 (e.g., a crimp) bent inwardly may be formed at an open end of the body portion 38b.

The beading part 31 can reduce or prevent movement of the electrode assembly 30 inside the case 38 and can facilitate seating of the gasket 32 and the cap assembly 50. The crimping part 33 may firmly fix the cap assembly 50 by pressing the edge of the case 38 against the gasket 32. The case 38 may be formed of, for example, iron plated with nickel.

The cap assembly 50 may be fixed to the inside of the crimping part by a gasket 32 to seal the case 38. The cap assembly 50 may include an upper cap 51, a safety vent 52, a lower cap 53, an insulating member, and a sub plate 54. but batteries according to the present disclosure are not limited to such a configuration and may be modified in various ways.

The upper cap 51 may be positioned at the uppermost part of the cap assembly 50. The upper cap 51 may include a terminal part that protrudes upwardly and is connected to an external circuit. The upper cap 51 may also include an outlet arranged around the terminal part for discharging gas. The safety vent 52 may be positioned under the upper cap 51. The safety vent 52 may include a protrusion part that protrudes convexly downwardly and is connected to the sub plate 54. At least one notch may be formed in the safety vent 52 around the protrusion part. When gas is generated due to overcharging or abnormal operation of the secondary battery, the protrusion part may be deformed upwardly by the gas pressure and separate from the sub plate 54 while the safety vent 52 opens (e.g., bursts or tears) along the notch. Thus, the cut safety vent 52 may prevent the secondary battery from exploding by allowing for the gas to be discharged to outside of the secondary battery.

The lower cap 53 may be positioned below the safety vent 52. The lower cap 53 may have a first opening for exposing the protrusion part of the safety vent 52 and a second opening for gas discharge. The insulating member may be positioned between the safety vent 52 and the lower cap 53 to insulate the safety vent 52 and the lower cap 53.

The sub plate 54 may be positioned under the lower cap 53. In particular, the sub plate 54 may be fixed to a lower surface of the lower cap 53 to block the first opening of the lower cap 53, and the protrusion part of the safety vent 52 may be fixed to the sub plate 54. The first lead tab 35, which extends from the electrode assembly 30, may be fixed to the sub plate 54. Accordingly, the upper cap 51, the safety vent 52, the lower cap 53, and the sub plate 54 may be electrically connected to the first electrode 30c of the electrode assembly 30.

The insulating plate 37 may be positioned in contact with the electrode assembly 30 below the beading part 31. The insulating plate 37 may have a tab opening through which the first lead tab 35 extends. The cap assembly 50, which is electrically connected to the first electrode 30c by the first lead tab 35, may face the electrode assembly 30 with an insulating plate 37 interposed therebetween. Thus, the cap assembly 50 may be electrically insulated from the electrode assembly 30 by the insulating plate 37. Another insulating plate 36 may be included for insulation between the electrode assembly 30 and the bottom portion 38a of the case 38.

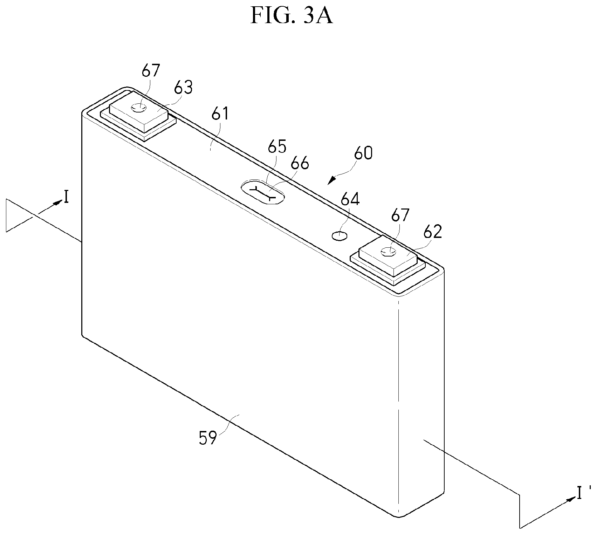

FIG. 3A is a top perspective view of a prismatic secondary battery.

A case 59 defines an overall appearance of the prismatic secondary battery. The case 59 may be made of a conductive metal, such as aluminum, aluminum alloy, or nickel-plated steel. In addition, the case 59 may provide a space for accommodating an electrode assembly therein.

A cap assembly 60 may include a cap plate 61 that covers the opening of the case 59. In some examples, the case 59 and the cap plate 61 may be made of a conductive material. A first terminal 63 and a second terminal 62 may be electrically connected to respective positive and negative (or negative and positive) electrodes inside the case. The terminals 62 and 63 may protrude outward through the cap plate 61.

The cap plate 61 may include an electrolyte injection port 64 with a sealing plug (or seal pin). And the cap plate 61 may include a vent 66 formed with a notch 65 for discharging gas generated inside the secondary battery.

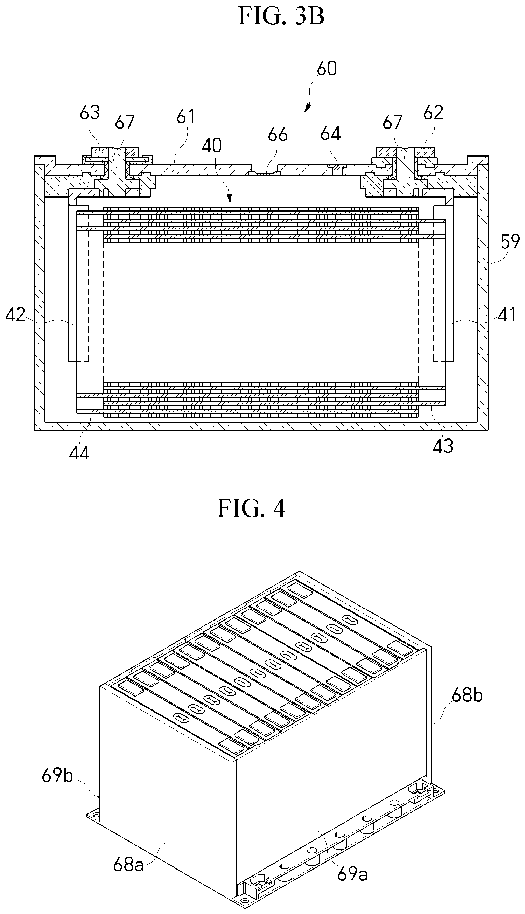

FIG. 3B is a cross-sectional view taken along the line I-I' of FIG. 3A and illustrates a prismatic secondary battery according to some embodiments of the present disclosure.

As shown in FIG. 3B, a prismatic secondary battery may include an electrode assembly 40, a first current collector 41, a first terminal 62, a second current collector 42, a second terminal 63, a case 59, and a cap assembly 60.

The electrode assembly 40 may be formed by winding or stacking a first electrode plate, a separator, and a second electrode plate, which are formed as thin plates or films. When the electrode assembly 40 is a wound stack, a winding axis may be along the longitudinal direction of the case 59. In other embodiments, the electrode assembly 40 is a stack type, and the shape of the electrode assembly 40 is not limited in the present disclosure. For example, the electrode assembly 40 may be a Z-stack electrode assembly in which a positive electrode plate and a negative electrode plate are provided to both sides of a separator, which is then bent into a Z-stack. In addition, one or more electrode assemblies may be stacked such that long sides of the electrode assemblies are adjacent to each other and accommodated in the case. In this regard, the number of electrode assemblies in the case is not limited in the present disclosure. The first electrode plate of the electrode assembly may act as a negative electrode, and the second electrode plate may act as a positive electrode. Of course, the reverse is also possible.

The first electrode plate may be formed by applying a first electrode active material, such as graphite, carbon, or the like, to a first electrode current collector formed of a metal foil, such as copper, a copper alloy, nickel, a nickel alloy, or the like. The first electrode plate may include a first electrode tab 43 (e.g., a first uncoated portion) that is a region where the first electrode active material is not provided. The first electrode tab 43 may act as a current flow path between the first electrode plate and the first current collector 41. In some embodiments, the first electrode tab 43 is formed by cutting such that the first electrode tab 43 protrudes from a side of the electrode assembly 40. In other examples the first electrode tab 43 protrudes from a side of the electrode assembly 40 more than (e.g., farther than or beyond) the separator without being separately cut.

The second electrode plate may be formed by applying a second electrode active material, such as a transition metal oxide, on a second electrode current collector formed of a metal foil, such as aluminum or an aluminum alloy. The second electrode plate may include a second electrode tab 44 (e.g., a second uncoated portion) that is a region where the second electrode active material is not provided. The second electrode tab 44 may act as a current flow path between the second electrode plate and the second current collector 42. In some embodiments, the second electrode tab 44 may be cut to protrude to the other side (e.g., the opposite side) of the electrode assembly. In other examples, the second electrode plate may protrude to the other side of the electrode assembly more than (e.g., farther than or beyond) the separator without being separately cut.

The separator prevents or substantially reduces instances of a short circuit between the first electrode and the second electrode while allowing movement of lithium ions between the first and second electrodes. The separator may be made of, for example, a polyethylene film, a polypropylene film, a polyethylene-polypropylene film, or the like.

In some embodiments, the electrode assembly 40 is accommodated in the case 10 along with an electrolyte.

In the electrode assembly 40, the first current collector 41 and the second current collector 42 may be welded and connected to the first electrode tab 43 extending from the first electrode plate and the second electrode tab 44 extending from the second electrode plate, respectively. In embodiments where the first electrode tab 43 and the second electrode tab 44 are located at the top of the electrode assembly 40, the first and second current collectors are located at the top of the electrode assembly 40.

As illustrated in FIG. 3B, the first current collector 41 and the second current collector 42 are connected to the first terminal 62 and the second terminal 63 through connection members 67. In some embodiments, the connection members 67 may each have an outer peripheral surface that is threaded, and the first and second terminals 62, 63 may be fastened to the connection members 67 by screwing. However, the present disclosure is not limited thereto. For example, the connection members 67 may also be coupled to the first terminal 62 and the second terminal 63 by riveting or welding.

FIG. 4 is a perspective view of a secondary battery module in which secondary batteries are arranged according to embodiments of the present disclosure. With the increased need for secondary battery capacity for driving electric vehicles or the like, a secondary battery module may be made by arranging a plurality of secondary battery cells transversely and/or longitudinally and connecting them together. The plurality of secondary batteries may be arranged in a space defined by a pair of facing end plates 68a and 68b and a pair of facing side plates 69a and 69b. The secondary batteries may be arranged in a direction and in a number to obtain desired voltage and current specifications.

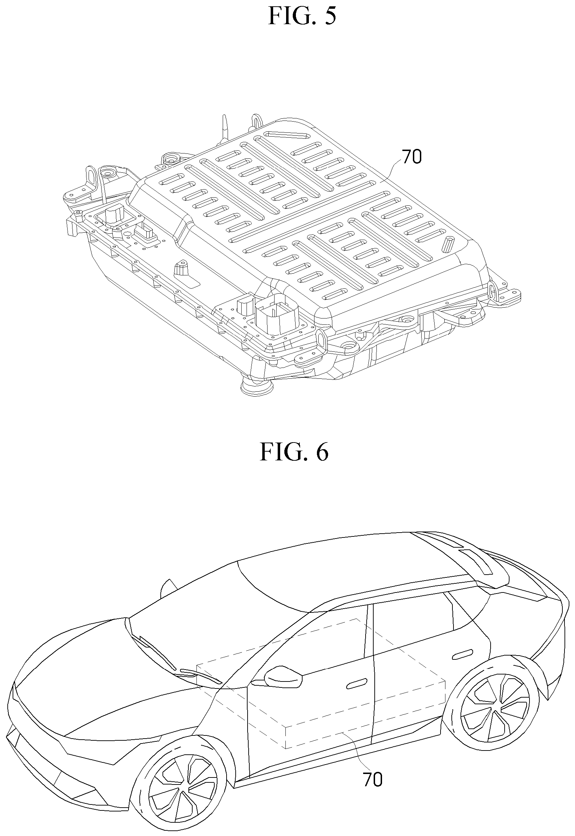

FIG. 5 is a perspective view of a battery pack 70 according to embodiments of the present disclosure. Referring to FIG. 5, the battery pack 70 may include an assembly in which individual batteries are electrically connected and a pack housing accommodating the assembly. In the drawings components including a bus bar, a cooling unit, external terminals for electrically connecting batteries, etc., are not shown.

The battery pack 70 may be mounted on (or in) a vehicle. The vehicle may be, for example, an electric vehicle, a hybrid vehicle, or a plug-in hybrid vehicle. The vehicle may be a four-wheeled vehicle or a two-wheeled vehicle, but is not limited thereto. FIG. 6 shows a vehicle that includes the battery pack 70 shown in FIG. 5 on the lower body thereof. The vehicle may operate by (e.g., may be powered by) receiving power from the battery pack 70.

The secondary battery pack may include a battery and a battery management system (BMS) for managing the battery. Using sensors, the BMS determines the voltage (V), current (I), and temperature (T) of batteries installed in, for example, electric vehicles or energy storage systems (ESS). As such, the BMS can control the batteries for optimal performance.

The battery management system may include a detection device, a balancing device, and a control device. The battery module may include a plurality of cells connected to each other in series and/or parallel. The battery modules may be connected to each other in series and/or in parallel.

The detection device may detect a state of a battery (e.g., voltage, current, temperature, etc.) to output state information indicating the state of the battery. For example, the detection device may detect the voltage of each cell constituting the battery or of each battery module. The detection device may detect current flowing through each battery module constituting the battery module or the battery pack. The detection device may also detect the temperature of a cell and/or module in at least one point of the battery and/or an ambient temperature.

The balancing device may perform a balancing operation of a battery module and/or cells constituting the battery module. The control device may receive state information (e.g., voltage, current, temperature, etc.) about the battery module from the detection device. The control device may monitor and calculate the state of the battery module (e.g., voltage, current, temperature, state of charge (SOC), life span

(state of health (SOH)), etc.) on the basis of the state information received from the detection device. In addition, based on the monitored state information, the control device may perform a control functions (e.g., temperature control, balancing control, charge/discharge control, etc.) and protection functions (e.g., over-discharge, overcharge, over-current protection, short circuit, fire extinguishing function, etc.). Further, the control device may perform a wired or wireless communication function with an external device of the battery pack (e.g., a higher level controller or vehicle, charger, power conversion system, etc.).

The control device may control charging/discharging operation and protection operation of the battery. To this end, the control device may include a charge/discharge control unit, a balancing control unit, and/or a protection unit.

In sum, the BMS monitors the battery state and performs diagnosis and control, communication, and protection functions, and may calculate the charge/discharge state, calculate battery life or state of health (SOH), cut off, as necessary, battery power (e.g., relay control), control thermal management (e.g., cooling, heating, etc.), perform a high-voltage interlock function, and/or may detect and/or calculate insulation and short circuit conditions.

In a battery system, a relay may be a mechanical contactor that is turned on and off by the magnetic force of a coil or a semiconductor switch, such as a metal oxide semiconductor field effect transistor (MOSFET). The relay control has a function of cutting off the power supply from the battery if, for example, a problem occurs in a vehicle that includes the battery system. The battery system and may include one or more relays and pre-charge relays at the positive terminal and the negative terminal.

In a battery system during pre-charge control, there is a risk of inrush current occurring in the high-voltage capacitor on the input side of the inverter when the battery load is connected. To prevent inrush current, for example, when starting a vehicle, the pre-charge relay may be operated before connecting the main relay and the pre-charge resistor may be connected.

A high-voltage interlock is a circuit that uses a small signal to detect, for example, whether or not all high-voltage parts of the entire vehicle system are connected. The high-voltage interlock may have a function of forcibly opening a relay if an opening occurs at a location on the entire loop.

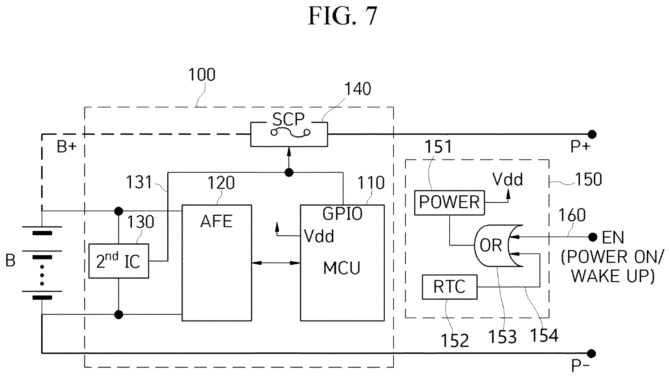

FIG. 7 is a schematic diagram illustrating a wake-up related configuration of a BMS.

Typically, a BMS 100 may include a micro-controller unit (MCU) 110 and an analog front-end (AFE) 120. A 2^{nd} protection circuit 130 may be added to prepare for an MCU failure. Power may be supplied to the BMS 100 from a power block 150.

The 2^{nd} protection circuit 130 may be connected to the battery B and may output a signal 131 when an abnormal condition of a voltage or temperature is detected. This output signal may be generally applied to a self control protector (SCP) 140, which is a fuse inside the BMS 100, and may be associated with a fuse blow signal. The AFE 120 may detect a voltage and may be used for a balancing function. A power supply 151 of the power block 150 may supply Vdd or Vcc power at a specific voltage (e.g., ranging from 3 V to 5 V) to the MCU 110 and related components.

When there is no charging or discharging of the battery B for a certain period of time, the BMS may enter the low power mode (sleep mode) or the power cut-off mode (shutdown mode). In such cases, a wake-up function may be periodically performed to turn the BMS on and check for abnormal behavior of the battery. For the periodic wake-up, the power block 150 may typically include a real time clock (RTC) 152. A clock signal 154 of the RTC 152 may be OR-ed with a power-on signal 160 or a wake-up signal EN of an external enable port by an OR circuit 153 to control the power supply 151.

In a conventional BMS 100, the wake-up function is performed periodically, which results in a certain amount of power being periodically consumed. Also, a separate circuit is provided for the periodic wake-up function.

According to the present disclosure, a wake-up function is executed only when a battery abnormality is detected. Thus, power consumption of the BMS may be reduced as compared to a configuration where the wake-up function is performed periodically.

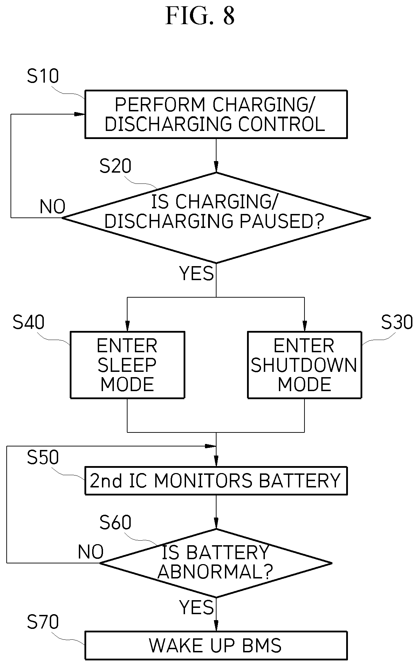

FIG. 8 is a flowchart of a BMS wake-up method according to embodiments of the present disclosure.

In the present disclosure the 2^{nd} protection circuit 130 and an output signal of the 2^{nd} protection circuit 130 are used as a BMS wake-up source in addition to the fuse blow signal 131. In a first step (S10) of a method according to the present disclosure, the BMS 100 may perform charging/discharging control. Next, it is determined whether the charging/discharging of the battery B is paused (S20). The BMS may then enter a shutdown mode (S30) or a sleep mode (S40).

While the BMS (or the MCU in the BMS) is in the shutdown or sleep mode, the 2^{nd} protection circuit 130 may monitor for an abnormality of the battery (e.g., an abnormal voltage or temperature) (S50). When the 2nd protection circuit 130 detects an abnormality in a battery cell (S60), the 2^{nd} protection circuit 130 may output a signal (a wake-up signal) to wake up the MCU (S70) of the BMS.

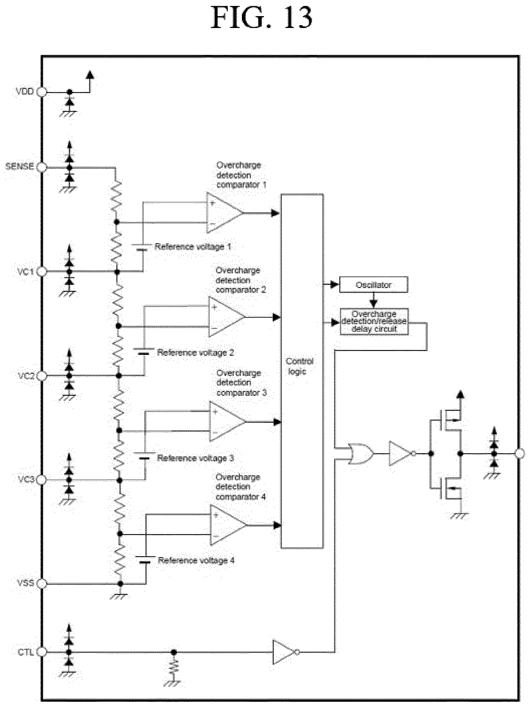

The 2^{nd} protection circuit 130 is a battery protection integrated circuit (IC) supplied as a commercial product, and representative products include S-8264A/B by Ablic Inc. and BQ77216 by Texas Instruments Inc. An internal circuit of S-8264A IC is shown in FIG. 13. The 2^{nd} protection circuit 130 has a configuration for monitoring a voltage or temperature of the battery cell and outputting a signal to an output port when a measured value exceeds a reference value.

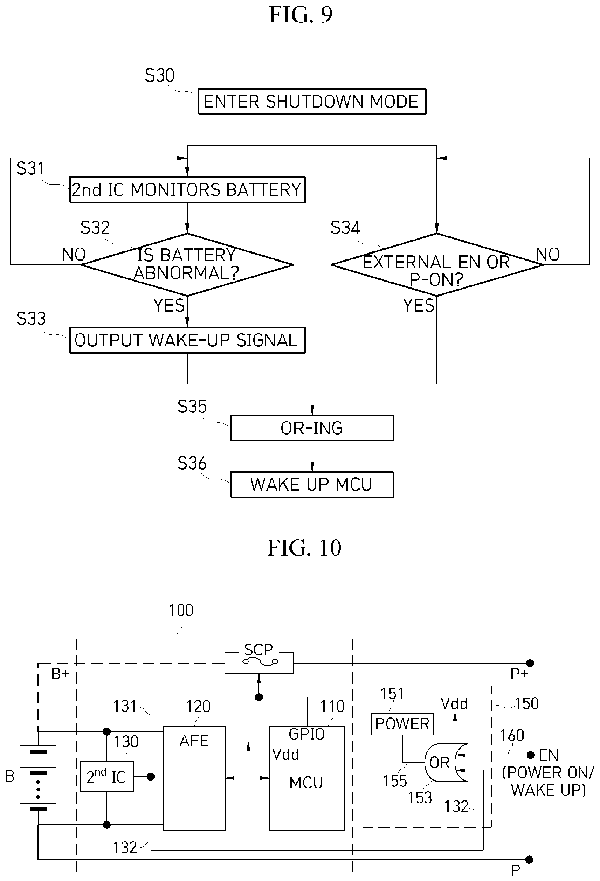

FIG. 9 is a flowchart of the BMS wake-up method in a shutdown mode. FIG. 10 is a diagram of a circuit that implements the BMS wake-up method of FIG. 9. An operation of a BMS wake-up according to embodiments of the present disclosure will be described with reference to FIGS. 9 and 10 together.

Referring to FIG. 9, while the BMS 100 is in the shutdown mode (S30), the 2^{nd} protection circuit 130 may monitor the battery (S31), and when an abnormality occurs (S32), output a wake-up signal 132 (S33). That is, the wake-up signal is output when the abnormality occurs and may be substantially the same as the fuse blow signal 131 applied to the fuse SCP 140, as described above.

Meanwhile, as shown in FIG. 10, when a wake-up enable (wake up EN) or the power-on (P-ON) signal 160 is applied (S34) from an external component during the shutdown mode (S30), the OR circuit 153 of FIG. 10 may wake up the MCU 110 by OR-ing the wake-up signal 132 of the 2^{nd} protection circuit 130 with the power-on signal 160 (S36). The wake-up of the MCU 110 may be achieved such that the OR-ed signal output from the OR circuit 153 activates the power supply 151 and the activated power supply 151 supplies power to the MCU 110.

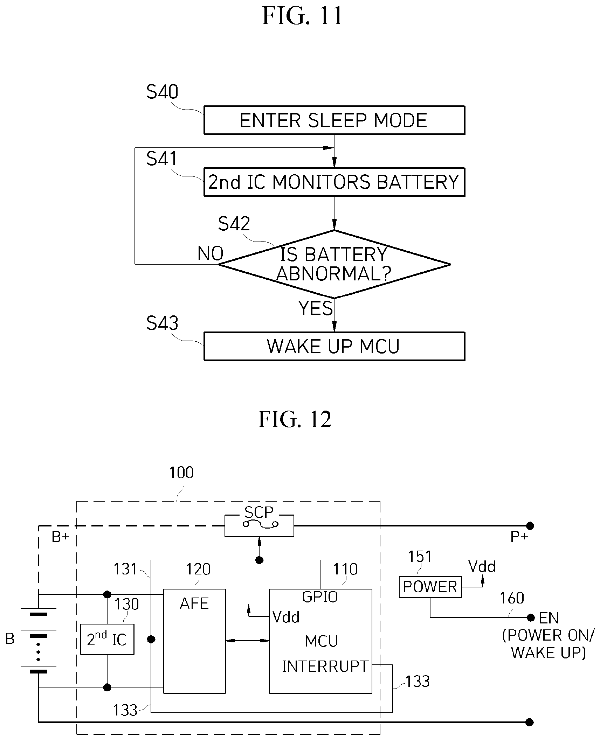

FIG. 11 is a flowchart of a BMS wake-up method in a sleep mode. FIG. 12 is a diagram of a circuit that implements the BMS wake-up method of FIG. 11. An operation of a BMS wake-up according to embodiments of the present disclosure will be described with reference to FIGS. 11 and 12.

The sleep mode is a mode in which power supplied to the BMS is not turned off and in which the MCU waits in the sleep mode when there is no charging/discharging operation of the battery. Further, the MCU periodically switches from the sleep mode to an active mode to monitor behavior of the battery.

Referring to FIG. 11, while the BMS 100 is in the sleep mode (S40), the 2^{nd} protection circuit 130 may monitor the battery (S41). When an abnormality occurs (S42), the 2^{nd} protection circuit may output a wake-up signal 133 (S43). In this case, the wake-up signal is output when the abnormality of the battery occurs and may be substantially the same as the fuse blow signal 131 applied to the fuse SCP 140, as described above.

As such, the wake-up signal 133 output from the 2^{nd} protection circuit 130 may wake up the MCU 110 (S43). In the sleep mode, because the power supply 151 supplies power to the MCU 110 as much as maintaining the sleep mode, the wake-up of the MCU 110 may be accomplished using various methods of activating the MCU 110, for example, using an interrupt function of the MCU.

According to the present disclosure, since abnormal behavior of a battery is monitored using a protection circuit that is included in a BMS without a separate circuit or component while the BMS is in a shutdown or sleep mode, a periodic wake-up as in the related art is no longer necessary. Thus, power consumption of the BMS may be reduced. Further, since an additional component such as an RTC circuit for the periodic wake-up is not needed, there is cost reduction, productivity improvement, and failure rate reduction in a BMS according to the present disclosure.

Although the present disclosure has been described above with respect to embodiments, the present disclosure is not limited to the embodiments. Various modifications and variations can be made thereto by those skilled in the art within the scope of the present disclosure.

## Claims

1. A battery management system comprising:
a micro-controller unit configured to manage a battery; and
a protection circuit configured to monitor the battery,
wherein, when the protection circuit detects an abnormality in the battery while the battery management system is in a shutdown mode or a sleep mode, the protection circuit is configured to output a wake-up signal to the BMS.

2. The battery management system as claimed in claim 1, further comprising:
an OR circuit configured to OR the wake-up signal output from the protection circuit with an external signal; and
a power supply activated by an output of the OR circuit and configured to wake up the battery management system by supplying power to the micro-controller unit.

3. The battery management system as claimed in claim 2, wherein the battery management system is configured to be woken up in the shutdown mode.

4. The battery management system as claimed in claim 2 or claim 3, wherein the external signal OR-ed in the OR circuit is one of an external wake-up enable signal or a power-on signal.

5. The battery management system as claimed in claim 1, wherein the wake-up signal output from the protection circuit triggers an interrupt function of the micro-controller unit to wake up the battery management system.

6. The battery management system as claimed in claim 5, wherein the battery management system is configured to be woken up in the sleep mode.

7. The battery management system as claimed in any preceding claim, wherein an abnormality of the battery detected by the protection circuit includes an abnormality of a voltage of the battery.

8. The battery management system as claimed in any preceding claim, wherein an abnormality of the battery detected by the protection circuit includes an abnormality of a temperature of the battery.

9. The battery management system as claimed in any preceding claim, wherein the wake-up signal output from the protection circuit comprises a fuse blow signal.

10. A wake-up method of a battery management system comprising a micro-controller unit and a protection circuit configured to monitor a battery, the wake-up method comprising:
using the micro-controller unit to determine that charging/discharging of the battery is completed or paused and putting the battery management system into a shutdown mode or a sleep mode;
monitoring, by the protection circuit, the battery while the battery management system is in one of the shutdown mode and the sleep mode; and
waking up the battery management system by the protection circuit outputting a wake-up signal when the protection circuit detects an abnormality of the battery.

11. The wake-up method as claimed in claim 10, further comprising:
OR-ing the wake-up signal output from the protection circuit with an external signal while the battery management system is in the shutdown mode; and
activating, by the OR-ed signal, a power supply configured to supply power to the micro-controller unit and supplying, by the activated power supply, power to the micro-controller unit to wake up the battery management system.

12. The wake-up method as claimed in claim 11, wherein the external signal OR-ed with the wake-up signal includes one of a wake-up enable signal or a power-on signal from an external component.

13. The wake-up method as claimed in claim 10, further comprising waking up the battery management system from the sleep mode using an interrupt function of the micro-controller unit triggered by the wake-up signal output from the protection circuit.

14. The wake-up method as claimed in any of claims 10 to 13, wherein the abnormality of the battery detected by the protection circuit comprises any one or more of an abnormality of a voltage and an abnormality of a temperature of the battery.

15. The wake-up method as claimed in any of claims 10 to 14, wherein the wake-up signal output from the protection circuit comprises a fuse blow signal.
